Europäisches Patentamt

European Patent Office

Office européen des brevets

(11) Veröffentlichungsnummer: **0 341 689**
**A2**

(12) **EUROPÄISCHE PATENTANMELDUNG**

(21) Anmeldenummer: 89108402.2

(22) Anmeldetag: 10.05.89

(51) Int. Cl.⁴: **H03K 17/00 , G05B 19/02**

(30) Priorität: 13.05.88 DE 3816369

(43) Veröffentlichungstag der Anmeldung:
15.11.89 Patentblatt 89/46

(84) Benannte Vertragsstaaten:
AT BE CH DE ES FR GB IT LI NL SE

(71) Anmelder: Klöckner-Moeller Elektrizitäts GmbH
Hein-Moeller-Strasse 7-11
D-5300 Bonn 1(DE)

(72) Erfinder: Hoss, Michael, Dipl.-Ing.
Lindenthalgürtel 103
D-5000 Köln 41(DE)

(54) Befehlsgerät.

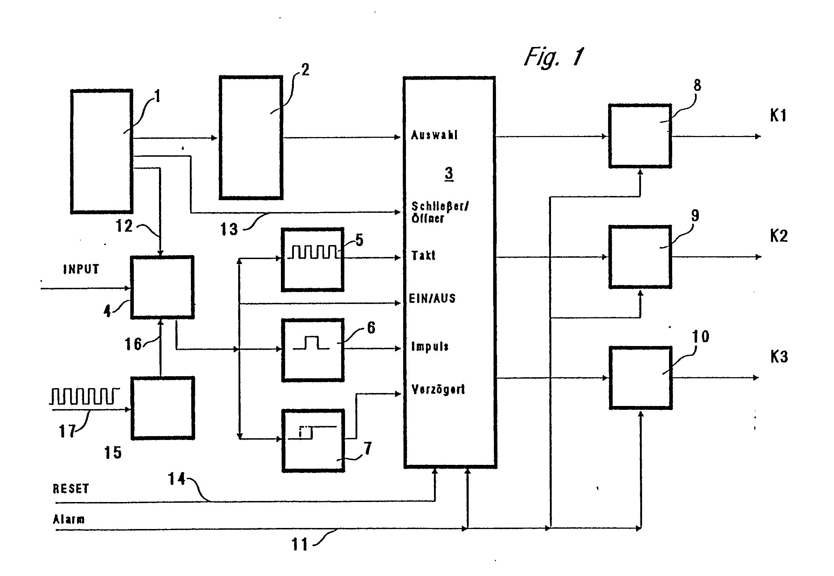

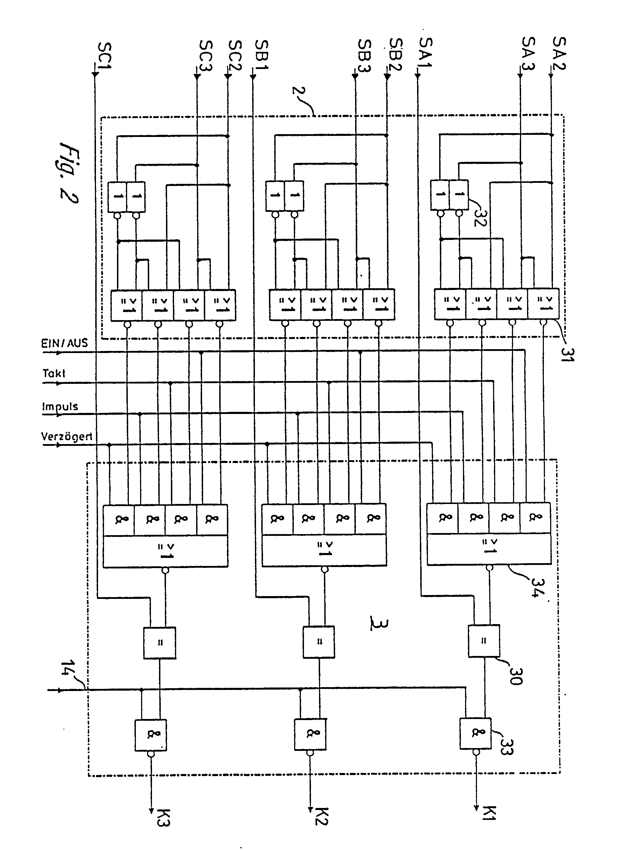

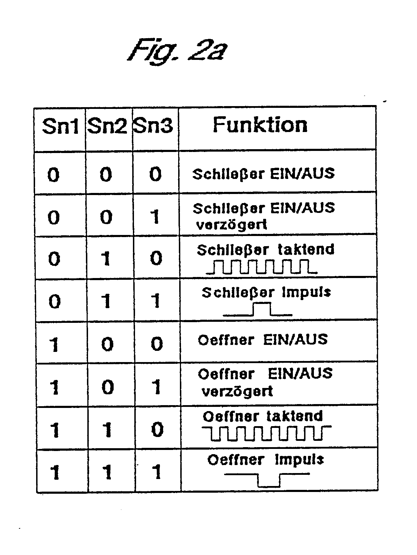

(57) Ein Befehlsgerät mit elektronischen Schaltelementen weist eine Programmiereinrichtung 1 auf, mit der die Funktionsvorwahl für die elektronischen Schaltelemente K1K3 vorgenommen wird. Die Programmiereinrichtung 1 ist in dem Gehäuse integriert und beeinflußt eine für die Funktionsauswahl bestimmte Schaltungsanordnung Fig. 2, der als Funktionsangebot die Funktionen EIN/AUS, Takt, Impuls, Verzögert von den Funktionsblöcken 4, 5, 6, 7 zur Verfügung gestellt werden. Das Befehlsgerät weist vor allem den Vorteil auf, daß eine Typenvielfalt vermieden wird und die Funktionsvorgabe direkt vom Anwender vorgenommen wird und jederzeit veränderbar ist. Die gesamte Schaltungsanordnung Fig. 1 ist als integrierter Schaltkreis ausgeführt und in dem Schaltgehäuse 21 untergebracht.

Fig. 1

EP 0 341 689 A2

Xerox Copy Centre

Die Erfindung betrifft ein Befehlsgerät, bestehend aus einem Betätigungselement und einem Gehäuse zur Aufnahme eines oder mehrerer elektronischer Schaltelemente.

Bekannte Befehlsgeräte der eingangs genannten Art sind in Modultechnik ausgeführt. Die Module sind miteinander kombinierbar, wobei jedes Modul ein kontaktloses Schaltelement mit beliebiger Funktionsweise aufweist. In der DE-OS 26 17 606 wird beispielsweise ein Explosionsgeschützter Paketnockenschalter beschrieben, der aus mehreren formschlüssig aneinandergereihten, gleichförmigen Gehäuseelementen besteht, welche als Universalschaltkammerelemente ausgebildet sind. Jedes dieser Universalschaltkammerelemente kann, nach Anspruch 2, elektronische Schaltelemente mit unterschiedlicher Funktionsweise beinhalten. Die DE-OS 36 11 579 bezieht sich auf ein elektronisches Schaltgerät, das eine in einem Gehäuse befindliche Leiterplatte aufweist, auf der sich eine elektronische Schaltung mit einem Sensor befindet. Dieses elektronische Schaltgerät ist als Modul mit anderen gleichförmigen Modulen zu einem Schaltblock kombinierbar, wobei alle den Schaltblock bildenden Schaltgeräte von nur einem Befehlselement betätigt werden. Auch hierbei ist die Funktionsweise der einzelnen Schaltgerätemodule beliebig. Nach diesem beschriebenen Stand der Technik ist die Änderung der Funktionsweise eines gattungsgemäßen Befehlsgerätes nur mit relativ großem Aufwand durchführbar. Dabei ist für jede Schaltfunktion ein seperates Modul als Kontaktträger zu montieren und entsprechend zu verdrahten. Die indirekte Beeinflussung und Funktionsvorgabe wird z.B. mit einer speicherprogrammierbaren Steuerung realisiert. Hierbei wird ein kontaktloses oder ein kontaktbehaftetes Befehlsgerät mit dem Eingang einer SPS verbunden, welche das Eingangssignal auf gewünschte Schaltfunktionen aufarbeitet. Diese bekannten und gängigen Verfahren haben den Nachteil, daß zum einen ein großer Hardwareaufwand Montage und Verdrahtung betrieben werden muß, und daß sich zum anderen die Zykluszeit der SPS negativ auf das zeitliche Schaltverhalten des Befehlsgerätes auswirkt. Außerdem sind Anwendungsbereiche für Befehlsgeräte gegeben, bei denen aus wirtschaftlichen Gründen der Einsatz einer SPS oder ähnliche Steuerungssysteme nicht tragbar ist.

Die Erfindung stellt sich daher die Aufgabe, ein Befehlsgerät zu schaffen, welches dem Anwender die Möglichkeit bietet, ohne zusätzliche Montage und Verdrahtungsarbeiten, auf einfache Art und Weise die Bestimmung der Schaltfunktion des Befehlsgerätes zu beeinflussen und somit die digitalen Steuerungsanforderungen an die Befehlsebene mit nur einer Befehlsgerätetype zu realisieren.

Diese Aufgabe wird erfindungsgemäß durch die im Anspruch 1 gekennzeichneten Merkmale gelöst, indem sich in dem Gehäuse befinden:

Funktionsblöcke , die den Schaltelementen als Funktionsangebot zur Verfügung stehen, eine Programmiereinrichtung zur Funktionsvorwahl für die Schaltelemente , die auf einen Eingang einer Auswahlschaltung wirkt, welche die Schaltelemente zur Ausführung der ausgewählten Funktion veranlaßt und Interfaceeinrichtungen zur Signalanpassung der ausgewählten Schaltfunktion an die Schaltelemente.

Vorteilhafte Ausbildungen des erfindungsgemäßen Befehlsgerätes sind in den Unteransprüchen 2 bis 13 gekennzeichnet. Nach den Ansprüchen 2 bis 5 ist es von besonderem Vorteil, daß der Auswahlschaltung durch Beeinflussung der Programmiereinrichtung die Funktion Schließer oder Öffnerverhalten oder die Funktion Schließer oder Öffnerverhalten und verzögertes Schaltverhalten oder die Funktion Schließer oder Öffnerverhalten und monostabiles Schaltverhalten oder die Funktion Schließer oder Öffnerverhalten und astabiles Schaltverhalten zur Verfügung steht. Weiterhin ist es wesentlich, daß nach Anspruch 6 durch Beeinflussung der Programmiereinrichtung der Funktionsblock die Schaltfunktionen Tastend oder Rastend selektiert, wobei der Funktionsblock den Schaltfunktio nen - EIN/AUS, Takt, Impuls Verzögert- übergeordnet ist und daß nach Anspruch 7 das Eingangssignal auf den Funktionsblock einwirkt, der das Funktionsangebot für die Schaltfunktionen -EIN/AUS, Takt, Impuls, Verzögertaktiviert. Nach Anspruch 8 sind Interfaceeinrichtungen vorgesehen sind, die das von der Auswahlschaltung ausgewählte Signal für die Ansteuerung der Schaltelemente auf deren leistungspezifisches Niveau bringen. Vorteilhaft ist es, nach Anspruch 9, daß ein Anschlußelement Einrichtungen zur Aufnahme optischer Statusanzeigen für die Schaltfunktionen jedes Schaltelementes aufweist. Zweckmäßigerweise ist die Schaltungsanordnung, nach Anspruch 10, als integrierter Schaltkreis ausgeführt . Nach Anspruch 11 sind an dem Anschlußelement Einrichtungen zur Aufnahme von Anschlußvorrichtungen vorgesehen , über die die Anschlußleitungen für die Versorgungsspannung, des Eingangssignals, des Resetsignals und des Alarmsignals angeschlossen werden und über die der Schaltsignalabgriff der Schaltelemente erfolgt. Nach den Ansprüchen 12 und 13 ist es zweckmäßig, daß durch die Programmiereinrichtung für jedes Schaltelement gleiche oder unterschiedliche Schaltfunktionen vorgewählt werden und daß unabhängig von der Anzahl der Schaltelemente die Funktionsblöcke einmal vorhanden sind. Schließlich ist es nach den Ansprüchen 14 und 15 von Vorteil daß die Grundfrequenz durch eine Schaltungsanordnung im zeitlichen Verhalten veränderbar ist und daß das zeitliche Verhalten der Funktionsblöcke von der veränderbaren Grundfrequenz abhängig ist.

Nachstehend wird die Erfindung anhand von in der Zeichnung dargestellten, beispielhaften Ausführungsformen näher erläutert.

Es zeigen :

Fig. 1 ein Blockschaltbild der programmierbaren Funktionsvorgabe des erfindungsgemäßen Befehlsgerätes.

Fig. 2 das Schaltbild der Decodierschaltung und der Ausführungsform der programmierbaren Funktionsvorgabe.

Fig. 2a die Darstellung der Funktionstabelle für die Programmierung der Schaltfunktionen der elektronischen Schaltelemente K1-K3 nach der Erfindung.

Fig. 3 das Befehlsgerät mit Betätigungselement Gehäuse und Anschlußelement.

Fig. 4 das in das Gehäuse integrierte Anschlußelement mit den optischen Statusanzeigen, den Anschlußvorrichtungen und der Programmiereinrichtung.

Fig. 1 zeigt ein Blockschaltbild der programmierbaren Funktionsvorgabe des erfindungsgemäßen Befehlsgerätes mit einer beispielhaften Darstellung für drei Schaltelemente. Die Auswahlschaltung 3 besteht primär aus der in Fig. 2 dargestellten Verknüpfungslogik. Ihr werden die Funktionsvorgaben von den Funktionsblöcken 4, 5, 6, 7, zur Selektierung angeboten und sie ordnet die Funktionen entsprechend der in der Programmiereinheit 1 eingeprägten Vorgaben den Schaltelementen K1, K2, K3 zu. Die Programmierung der Programmiereinheit 1 kann beispielsweise mittels DIP-Schalter 26 erfolgen und wird über die Dekodiereinrichtungen 2 der Auswahlschaltung 3 zugeführt. Die Funktionsvorgabe Schließer- oder Öffnerverhalten wird der Auswahlschaltung 3 mittels der Signalleitung 13 direkt von der Programmiereinrichtung 1 geliefert. Mit dem Eingangssignal INPUT werden die Funktionsblöcke Taktschaltung 5, Impulsschaltung 6, und Verzögerungsschaltung 7 aktiviert, wobei vorrangig zu diesen Schaltfunktionen die Funktion Tastend oder Rastend durch die Vorgabe der Programmiereinrichtung 1 über die Signalleitung 12 und dem Funktionsblock 4 erfolgt. Das zeitliche Verhalten der Funktionsblöcke 4, 5, und 6 wird durch die veränderbare Grundfrequenz 17 bestimmt. Erzeugt wird die Grundfrequenz beispielsweise durch einen Schwingquarz oder eine RC-Schaltung. Die Schaltungsanordnung 15 sorgt für eine Frequenzuntersetzung, die durch Überbrückung bestimmter Anschlußpins des Chips extern gewählt werden kann. Die entsprechend untersetzte Grundfrequenz wird der Schaltungsanordnung 4 über Signalleitung 16 zugeführt und bestimmt das zeitliche Verhalten von Takt, Impuls und Verzögerungsschaltung. Die Auswahlschaltung 3 führt die entsprechenden Funktionen den Schaltelementen K1, K2, K3 zu. Bei der Anfangsinitialisierung, d.h. Spannungszuschaltung oder bei Wiederkehr der Spannung nach einem Spannungseinbruch werden die Interfaceeinrichtungen 8, 9, 10 durch einen externen RESET in einen definierten Schaltzustand gesetzt. Ein externes statisches Signal auf die Eingangsleitung ALARM verursacht ein Sperren aller Interfaceeinrichtungen 8, 9, 10.

Fig. 2 zeigt das Schaltbild der Decodiereinrichtung und der Auswahlschaltung für die nach der Fig. 1 dargestellte Ausführungsform der programmierbaren Funktionsvorgabe des erfindungsgemäßen elektronischen Schaltelementes. Mit den von der Programmiereinrichtung 1 kommenden Vorwahlleitungen SA1-SA3, SB1 - SB3 und SC1 - SC3 werden die Funktionsvorgaben für die elektronischen Schaltelemente K1 - K3 zur Dekodiereinrichtung 2 transportiert. Der logische Schaltungsaufbau für die Decodierschaltung 2 und für die Auswahlschaltung 3 ist für jedes Schaltelement gleich. Für das Schaltelement K1 wird mittels der Vorwahlleitung SA1 und des Äquivalentbausteins 30 die Funktion Öffnerverhalten oder Schließerverhalten des Kontaktelementes K1 vorgewählt. Die Vorwahlleitungen SA2 und SA3 bestimmen, je nach ihrem Signalpegel die Schaltfunktion des Schaltelementes K1. Die Decodierung wird durch die logische Verknüpfung der NOR-Bausteine 31 und der NAND-Bausteine 32 innerhalb der Decodierschaltung 2 erreicht. Die Anzahl der Schaltelemente ist in diesem Beispiel auf drei festgelegt, sie kann aber beliebig variiert werden. In der Fig. 2a ist die Funktionstabelle für die Programmierung der Schaltfunktionen der elektronischen Schaltelemente K1-K3 dargestellt. Die Schaltfunktionen EIN/AUS, Takt, Impuls und Verzögert werden direkt der Auswahlschaltung 3 zugeführt und sind für jedes Schaltelement K1-K3 verfügbar. Die programmierte Schaltfunktion wird dem Äquivalenzbaustein 30 über die Eingangsverknüpfung 34 zugeführt. Je nach Signalpegel der Vorwahlleitung SA1 wird das Funktionssignal zu dem NAND-Baustein 33 direkt oder invertiert durchgeschaltet. Hierdurch wird das Öffner/Schließerverhalten erreicht. Durch die Verknüpfung des Funktionssignals mit dem Signal 11, mittels des NAND-Bausteins 33 wird das Schaltelement K1 im Störfall abgeschaltet. Die vorgehende Beschreibung gilt ebenso für die Schaltelemente K2 und K3 entsprechend des Signalpegels ihrer Vorwahlleitungen SB1- SB3 und SC1- SC3. Die Programmierung der Funktionsvorwahl ist in diesem Beispiel mit Vorwahlschaltern, z.B. DIP-Schaltern 26, vorgesehen. Statt der DIP-Schalter könnte die Programmierung auch über andere Programmiermedien erfolgen. Bei Automatisierungssystemen ist beispielsweise die Ansteuerung der Funktionsvorwahl für die Schaltelemente über ein Bussystem oder direkte Ansteuerung durch speicherprogrammierbare Steuerungen vorteilhaft. Das Funktionssignal für die Schaltelemente K1- K3 wird durch die Interfaceein richtungen 8, 9, 10 über Leistungstreiber oder potentialgetrennt über Optokoppler oder anderen Signalaufbereitungselementen den Anschlußvorrichtungen 23 zugeführt.

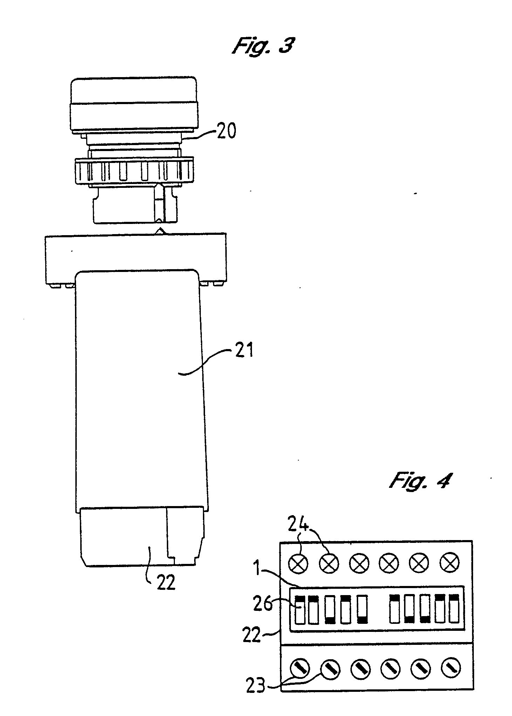

In Fig. 3 ist eine beispielhafte Ausführungsform des Befehlsgerätes mit dem Betätigungselement 20 und dem Gehäuse 21 dargestellt. Das Betätigungselement 20 ist als Einbauelement, beispielsweise in eine Schaltschranktür, vorgesehen. Das Gehäuse 21 ist formschlüssig auf das Betätigungselement aufschnappbar. Das Anschlußelement 22 ist integraler Bestandteil des Gehäuses 21 und in Fig. 4 dargestellt. Die Programmiereinrichtung besteht hierbei aus zehn DIP-Schaltern 26 wobei drei DIP-Schalter für die Funktionsvorgabe eines Schaltelementes vorgesehen sind und ein DIP-Schalter allen vorhandenen Schaltelementen die Funktion Tastend oder Rastend vorgibt. Für jede Funktion sind optische Statusanzeigen 24 vorgesehen. Der Anschluß der Spannungsversorgung, und der Abgriff der Schaltelemente erfolgt an den Anschlschlußvorrichtungen 23. Außerdem ist eine Anschlußmöglichkeit für einen externen Eingang, parallel zum Eingangssignal INPUT des Befehgerätes vorgesehen. Die Anschlußvorrichtungen können in allen bekannten Anschlußtechniken ausgeführt sein.

**Ansprüche**

1. Befehlsgerät, bestehend aus einem Betätigungselement und einem Gehäuse zur Aufnahme eines oder mehrerer elektronischer Schaltelemente, **dadurch gekennzeichnet**, daß sich in dem Gehäuse (21) befinden:
Funktionsblöcke (4, 5, 6, 7), die den Schaltelementen (K1-K3) als Funktionsangebot (EIN/AUS, Takt, Impuls, Verzögert) zur Verfügung stehen,
eine Programmiereinrichtung (1) zur Funktionsvorwahl für die Schaltelemente (K1-K3), die auf einen Eingang (Vorwahl) einer Auswahlschaltung (3) wirkt, welche die Schaltelemente (K1-K3) zur Ausführung der vorgewählten Funktion veranlaßt,
und Interfaceeinrichtungen (8, 9, 10) zur Signalanpassung der ausgewählten Schaltfunktion an die Schaltelemente (K1-K3).

2. Befehlsgerät nach Anspruch 1, **dadurch gekennzeichnet**, daß die Schaltungsanordnung (Fig. 1) als integrierter Schaltkreis ausgeführt ist und daß die Auswahlschaltung (3) mittels der Programmiereinrichtung (1) derart beeinflußbar ist, daß für die Schaltelemente (K1-K3) die Funktionen Schließer- oder Öffnerverhalten und, mittels des Funktionsblocks (7), verzögertes Schaltverhalten oder, mittels des Funktionsblocks (6), monostabiles Schaltverhalten oder, mittels des Funktionsblocks (5), astabiles Schaltverhalten zur Verfügung steht.

3. Befehlsgerät nach Anspruch 1 und 2 **dadurch gekennzeichnet**, daß der Funktionsblock (4) durch die Programmiereinrichtung (1) derart beeinflußbar ist, daß die Schaltfunktionen Tastend oder Rastend vorgegeben werden, wobei der Funktionsblock (4) den Schaltfunktionen (EIN/AUS, Takt, Impuls, Verzögert) übergeordnet ist.

4. Befehlsgerät nach den Ansprüchen 1 bis 3, **dadurch gekennzeichnet**, daß das Eingangssignal (INPUT) auf den Funktionsblock (4) einwirkt, der das Funktionsangebot für die Schaltfunktionen (EIN/AUS, Takt, Impuls, Verzögert) aktiviert.

5. Befehlsgerät nach den Ansprüchen 1 bis 4, **dadurch gekennzeichnet**, daß Interfaceeinrichtungen (8, 9, 10) vorgesehen sind, die das von der Auswahlschaltung (3) ausgewählte Signal für die Ansteuerung der Schaltelemente (K1-K3) auf deren leistungspezifisches Niveau bringen.

6. Befehlsgerät nach den Ansprüchen 1 bis 5, **dadurch gekennzeichnet**, daß ein Anschlußelement (22) Einrichtungen (24) zur Aufnahme optischer Statusanzeigen für die Schaltfunktionen jedes Schaltelementes (K1-K3) aufweist.

7. Befehlsgerät nach den Ansprüchen 1 bis 7, **dadurch gekennzeichnet**, daß an dem Anschlußelement (22) Einrichtungen zur Aufnahme von Anschlußvorrichtungen (26) vorgesehen sind, über die die Anschlußleitungen für die Versorgungsspannung, des Eingangssignals (INPUT), des Signals (RESET) und des Signals (ALARM) angeschlossen werden und über die der Schaltsignalabgriff der Schaltelemente (K1-K3) erfolgt.

8. Befehlsgerät nach den Ansprüchen 1 bis 11, **dadurch gekennzeichnet**, daß durch die Programmiereinrichtung (1) für jedes Schaltelement (K1-K3) gleiche oder unterschiedliche Schaltfunktionen vorgewählt werden.

9. Befehlsgerät nach den Ansprüchen 1 bis 12, **dadurch gekennzeichnet**, daß unabhängig von der Anzahl der Schaltelemente die Funktionsblöcke (4, 5, 6, 7) einmal vorhanden sind.

10. Befehlsgerät nach den Ansprüchen 1 bis 13, **dadurch gekennzeichnet**, daß die Grundfrequenz (17) durch die Schaltungsanordnung (15) im zeitlichen Verhalten veränderbar ist und daß das zeitliche Verhalten der Funktionsblöcke (5, 6, 7) von der veränderbaren Grundfrequenz (17) abhängig ist.

Klöckner Moelle
Elektrizitäts G

8.Mai 89
070-27/EP

INPUT

17

15

16

4

12

1

13

2

RESET

Alarm

14

11

7

6

5

Verzögert

Impuls

EIN/AUS

Takt

Schließer/
Öffner

Auswahl

3

10

9

8

K3

K2

K1

*Fig. 1*

EP 0 341 689 A2

Klöckner Moellei
Elektrizitäts Gr

8.Mai 89
070-27/EP

Fig. 2

Klöckner Moelle
Elektrizitäts G

8.Mai 89
070-27/EP

# Fig. 2a

| Sn1 | Sn2 | Sn3 | Funktion |
|:---:|:---:|:---:|:---|
| 0 | 0 | 0 | Schließer EIN/AUS |
| 0 | 0 | 1 | Schließer EIN/AUS verzögert |
| 0 | 1 | 0 | Schließer taktend |
| 0 | 1 | 1 | Schließer Impuls |
| 1 | 0 | 0 | Oeffner EIN/AUS |
| 1 | 0 | 1 | Oeffner EIN/AUS verzögert |
| 1 | 1 | 0 | Oeffner taktend |
| 1 | 1 | 1 | Oeffner Impuls |

Klöckner Moelle
Elektrizitäts G

8.Mai 89
070-27/EP

*Fig. 3*

20

21

22

*Fig. 4*

24

1

26

22

23